# EUROPEAN PATENT SPECIFICATION

(11) **EP 1 785 010 B1**
(45) Date of publication and mention of the grant of the patent: **08.04.2009**
(21) Application number: 05754666.5
(22) Date of filing: 31.05.2005
(51) Int. Cl.: H05B 6/32, C23C 14/26

(54) **APPARATUS AND METHOD FOR LEVITATION OF AN AMOUNT OF CONDUCTIVE MATERIAL**
VORRICHTUNG UND VERFAHREN ZUM SCHWEBEN LASSEN EINER MENGE LEITFÄHIGEN MATERIALS
APPAREIL ET PROCÉDÉ POUR LA LÉVITATION D'UNE CERTAINE QUANTITÉ DE MATÉRIAU CONDUCTEUR

(30) Priority: 23.08.2004 US 923505
(43) Date of publication of application: 16.05.2007
(73) Proprietor: Corus Technology BV, 1970 CA Ijmuiden (NL)
(72) Inventor: PRIEDE, Janis, Coventry CV3 1D (GB); BAPTISTE, Laurent, Christophe, Bernard, NL-1079 BT Amsterdam (NL); GLEIJM, Gerardus, NL-1971 KK Ijmuiden (NL); SCHADE Van Westrum, J.A.F.M., 6902 BC Zevenaar (NL)
(74) Representative: Kruit, Jan
(86) International application number: PCT/EP2005/005905
(87) International publication number: WO 2006/021245

(56) References cited:
- WO-A-03/071000
- US-A- 2 686 864
- US-A- 2 957 064
- US-A- 3 363 081
- US-A- 4 979 182
- US-A- 4 993 043

## Description

The invention relates to an apparatus for levitation of an amount of conductive material, comprising a coil for keeping the material in levitation using a varying electric current in the coil. The invention also relates to a method for generating an amount of levitated conductive material using the apparatus.

The levitation of conductive material is known for physical vapour deposition, a technology for coating a substrate with a layer of material that is condensed from the vapour phase on the substrate in a vacuum chamber. Usually such material is kept in a crucible and heated in that crucible to melt and vaporize. However, a lot of energy is lost since the crucible has to be cooled. Often, the crucible is attacked by the material to be evaporated. For these reasons, electromagnetic levitation has been developed, as described in WO 03/071000 A1.

In electromagnetic levitation, an amount of conductive material is kept floating above a coil in which a varying electric current is fed. Due to the varying electric current, an alternating electromagnetic field is generated in the coil. The electromagnetic field exerts an upward directed force on the conductive material. This electromagnetic force balances the gravitational force acting on the conductive material, to keep the conductive material levitated. Since the magnetic force varies with the distance to the coil, the conductive material will be kept in levitation (or float) above the coil at a distance that depends on the current in the coil and the mass of the conductive material.

The electric current also provides electrical energy for heating the conductive material, such that it melts and eventually evaporates. The evaporated material is used to coat substrates, such as strip material.

The above apparatus has the drawback that the varying electric current both provides the levitation force and the heating power for the amount of conductive material. When it is necessary to heat the material to a higher temperature, for instance because the material has a higher melting and evaporation temperature or because a higher evaporation rate is required, the current should be increased. However, the levitation force of the electromagnetic field is than increased at the same time, resulting in the floating of the material above the coil at a greater distance to the coil. At this distance, the electromagnetic field is less, resulting in a heating power for the material that is flower than intended.

US-A-2,957,064 discloses an apparatus and method for levitating, heating and melting electrically conductive materials using an alternating magnetic field in air, vacuum or inert gas. The alternating magnetic field is generated by a coil means. In order to stabilize the levitating position of the charge a non-energized stabilizing means are provided.

From US-A-4,993,043 and US-A-4,979,182 a device for positioning and melting electrically conductive materials without a receptacle is known, wherein two coils between which a sample is contactlessly held in a suspended state, form a common part of two different oscillating circuits, a heating oscillating-circuit and a positioning oscillating-circuit. These circuits can be set independently from each other.

US-A-3,363,081 also discloses a magnetic device to lift and melt a body without a holder. This known device comprises two cylindrical coils having the same horizontal axis and a cylindrical core made of conductive material located inside each coil.

US-A-2,686,864 has disclosed a device for magnetic levitation and heating of conductive materials by an alternating magnetic field in air, vacuum or inert gas atmosphere. The levitating field may be obtained by various configuration of the coils device comprises two coils. Once molten the conductive material is cast into a cup or mould.

It is an object of the invention to provide an improved apparatus for levitation and heating of an amount of conductive material.

It is another object of the invention to provide an apparatus for levitation of an amount of conductive material with which apparatus the heating power for heating the material can be controlled.

It is a further object of the invention to provide a method for generating an amount of levitated conductive material with which the evaporation of the conductive material can be controlled.

One or more of these objects are reached with an apparatus for levitation of an mount of conductive material, comprising a coil for keeping the material in levitation using a varying electric current in the coil, wherein the apparatus comprises two coils, a first coil and a second coil, both coils generating an alternating electromagnetic field during use, the alternating electromagnetic field of the first and second coil counteracting each other, wherein the first and second coil are positioned such that the conductive material that is kept in levitation between the first coil and the second coil is evaporated.

Using two coils makes it possible to generate two electromagnetic fields, such that the conductive material will be kept in levitation in a stable position between the two coils. Due to the counteracting force of the alternating magnetic fields in the two coils, the conductive material cannot move away from the coils. Since now the conductive material is kept in place, it is possible to generate a higher current and so a higher temperature in the conductive material. This results in an evaporation rate of the conductive material that is high enough to coat a substrate with a velocity that is economically viable.

The conductive material will often melt due to the heating before it evaporates, but some materials will sublimate before they melt.

Preferably the coils have substantially the same centre line. When the coils have the same centre line, the conductive material is entrapped in between the two magnetic fields in the best possible way. When the centre lines of the coils are displaced relatively, or enclose an angle, the conductive material is apt to leak out of the space between the coils when the conductive material is molten, and be lost for evaporation.

According to a preferred embodiment, the coils have windings that are all substantially closed loops. The magnetic fields generated by the coils will thus be substantially symmetrical around the centre line of each coil. The conductive material is thus kept centred in the space between the coils, and when the conductive material is molten, it will have a symmetrical shape corresponding to the symmetry in the magnetic field.

According to a first preferred embodiment, the coils each have a separate current supply. When the coils each have their own current supply, the magnitude of the current can be varied independent for each coil, and thus the levitation force and heating power can be varied, as can the distance between the coils. A drawback is that the alternating field of the coils must be well controlled.

According to a second preferred embodiment, the coils are connected and have the same current supply. In this way there is no problem with the phases of the magnetic fields, because the same current is used, but it is more difficult to form the coils because they are connected, and the distance cannot be changed after the coils are wound, and the heating power and levitation force cannot be varied independently of each other.

For this last preferred embodiment, preferably the coils are wound in opposite directions. Since the current flows in the same direction through the windings, in this way counteracting magnetic fields are generated in the coils.

According to a preferred embodiment, the first coil is situated substantially above the second coil. The gravity force acting on the levitated conductive material will then be substantially directed along the same line as the magnetic fields of the coils. The forces will thus be well-balanced.

Preferably, the first coil has the same number of windings or less winding than the second coil. In this way the magnetic field of the second (lower) coil is stronger than the magnetic field of the first (upper) coil, thus counteracting the gravity force and keeping the conductive material approximately halfway between the first and second coil.

According to a preferred embodiment, the first and second coils are mirror symmetric. With this configuration of the coils, the coils can be manipulated, as elucidated below.

According to a second aspect of the invention, provided is a method for generating an amount of levitated conductive material using an apparatus as discussed above, wherein the conductive material is entrapped in between the electromagnetic fields generated by the two coils so as to evaporate due to the heating by the current and frequency in the coils.

The entrapment of the conductive material between the two coils makes it possible to generate enough heating power in the conductive material when the current is increased, such that the conductive material evaporates at a rate that is high enough to be able to coat a substrate in an economically profitable way. In the known apparatus in which only one coil was used, for most materials the conductive material could not be heated to a temperature high enough to generate economic interesting evaporation rates for the coating of substrates.

Preferably, the evaporated conductive material is directed essentially along the direction of the centre line of the coils for the coating of a substrate. Use is made of an isolating means, such as a duct or tube, between the coils and the conductive material; in this way the evaporated material can be directed to the substrate to be coated, without condensation on parts of the apparatus.

According to a preferred embodiment the coils are manipulated together so as to direct the evaporated conductive material with one or more degrees of freedom. This is possible now the conductive material is entrapped between the coils and cannot leave the combined magnetic fields of the coils. By manipulating the coils, for instance by rotation, the evaporated material can be directed in another direction, which makes it far more easy to coat one or more substrates that are present in the vacuum chamber.

Preferably, the coils are manipulated with six degrees of freedom. The coils can thus move in three directions and rotate around two horizontal axes and one vertical axe.

According to a preferred method, the strength of the electromagnetic fields in the two coils is such that the conductive material entrapped in the electromagnetic fields is forced towards the centre line of the coils. This is especially useful when the evaporated material should be directed to a substrate that is not exactly above the coils. The coils can now be manipulated and the evaporated material directed in all directions, to coat substrates in the vacuum chamber.

The invention will be elucidated with reference to the accompanying drawing.

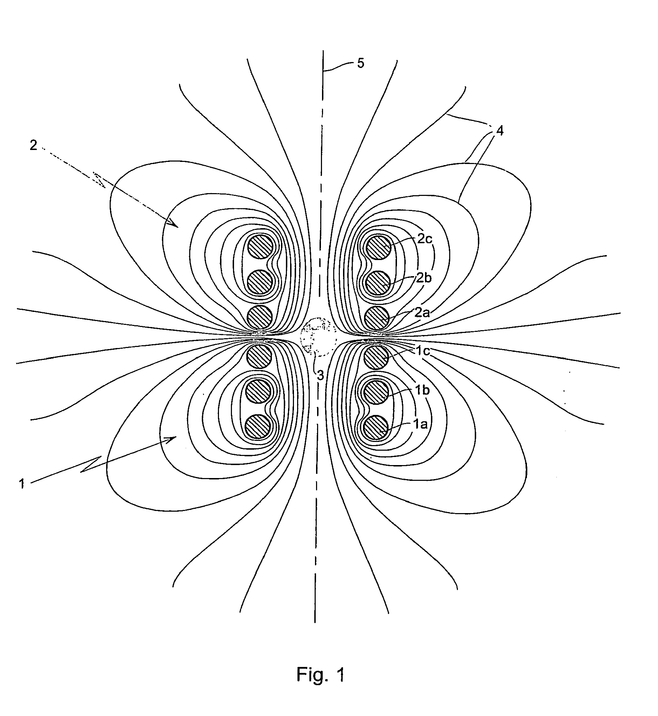

Fig. 1 shows in a schematic way the two coils according to the invention with the entrapped conductive material in cross-section.

Shown is a first coil 1 and a second coil 2, each coil consisting of three windings 1a, 1b, 1c and 2a, 2b, 2c. Coil 1 and coil 2 each produce an electromagnetic field, the field of coil 1 counteracting the field of coil 2 such that the resulting electromagnetic field entraps conductive material 3 that is provided between the coils. The electromagnetic fields are shown by the electromagnetic field lines 4.

As shown in the figure, due to the counteracting magnetic fields the strongest field is present between the two coils. This has the effect that the conductive material, here shown as a molten droplet, is forced towards the centre line 5 of the symmetric coils. Moreover, it means that the droplet cannot move out of the coils, and thus that a high current can be generated in the windings of the coils, resulting in a high heating power of the coils. The droplet will thus be heated to a high temperature and evaporate fast. The evaporation rate of the (super)heated conductive material is high, and the coating velocity of a substrate economically attractive.

It will be understood that more than two coils can be used, and that the windings can be circular, but also can have another shape, preferably axially symmetrical. The windings could for instance be square. Instead of three windings for each coil, it is possible to use less or more windings, and the number of windings can differ for each coil. When the two coils are not connected, a different magnitude of the current in each coil can be used.

The evaporated material will mainly flow in the direction of the centre line 5, in view of a duct or tube of non-conductive material placed between the coils and the droplet (not shown). This duct prevents arcing between the windings and contamination of the vacuum chamber. The apparatus according to the invention makes it possible to manipulate the coils together, such that the direction of the centre line is changed. In this way it is possible to coat a substrate not only from below or from above, but also sideways. It is also possible to displace the coils together in three directions. Due to the fact that the conductive material is entrapped between the two coils, the material will remain between the coils and evaporate before, during and after the manipulation.

It will be understood that for the physical vapour deposition according to this invention, the coils and the conductive material are kept in a vacuum of at least10⁻³ mbar. The varying electric current and the frequency used have to be high enough to heat and evaporate the conductive material, which is used, and depends on the type of conductive material and the coating velocity required.

## Claims

1. Apparatus for levitation of an amount of conductive material (3), comprising a coil for keeping the material in levitation using a varying electric current in the coil, wherein the apparatus comprises two coils (1, 2), a first coil (1) and a second coil (2), **characterised in that** both coils (1, 2) have been placed in a vacuum chamber for a vacuum of at least 10⁻³ mbar during use, both coils (1, 2) generating an alternating electromagnetic field during use, the alternating electromagnetic field of the first (1) and the second coil (2) counteracting each other, wherein the coils (1, 2) are rotateable and/or displaceable together so as to change the centre line (5) of the coils (1, 2), and wherein a tube of non-conductive material is placed inside the coils (1, 2) such that the tube is present between the coils (1, 2) and the conductive material (3) during use, and wherein the first (1) and second (2) coils are positioned such that the conductive material (3) that is kept in levitation between the first coil (1) and the second coil (2) is evaporated and the evaporated material flows along the direction of the centre line (5) of the coils(1, 2) inside the tube of non-conductive material to the substrate to be coated.

2. Apparatus according to claim 1, wherein the coils (1, 2) have windings (1a, 1b, 1c; 2a, 2b, 2c) that are all substantially closed loops.

3. Apparatus according to any one of claims 1 - 2, wherein the coils (1, 2) each have a separate current supply.

4. Apparatus according to any one of claims 1 - 2, wherein the coils (1, 2) are connected and have the same current supply.

5. Apparatus according to claim 4, wherein the coils (1, 2) are wound in opposite directions.

6. Apparatus according to any one of the preceding claims, wherein the first coil (1) is situated substantially above the second coil (2).

7. Apparatus according to claim 6, wherein the first coil (1) has the same number of windings or less windings than the second coil (2).

8. Apparatus according to any one of the preceding claims, wherein the first (1) and second (2) coils are mirror symmetric.

9. Method for generating an amount of levitated conductive material (3) using an apparatus according to any one of the preceding claims **characterised in that** the conductive material (3) is entrapped in between the electromagnetic fields generated by the two coils (1, 2) so as to evaporate due to the heating by the current and frequency in the coils, wherein the evaporated conductive material is directed essentially along the direction of the centre line (5) of the coils (1, 2) for the coating of a substrate.

10. Method according to claim 9, wherein the coils (1, 2) are manipulated together so as to direct the evaporated conductive material with one or more degrees of freedom.

11. Method according to claim 10, wherein the coils (1, 2) are manipulated with six degrees of freedom.

12. Method according to any one of the claims 9 - 11, wherein the strength of the electromagnetic field in the two coils (1, 2) is such that the conductive material (3) entrapped in between the electromagnetic fields is forced towards the centre line (5) of the coils (1, 2).

## Patentansprüche

1. Vorrichtung zum freien Schwebenlassen einer Menge leitenden Materials (3), umfassend eine Spule, um das Material durch Verwenden eines variierenden elektrischen Stroms in der Spule frei schwebend zu halten, wobei die Vorrichtung zwei Spulen (1, 2) umfasst, eine erste Spule (1) und eine zweite Spule (2), **dadurch gekennzeichnet, dass** bei Gebrauch beide Spulen (1, 2) in einer Vakuumkammer für ein Vakuum von mindestens 10³ mbar angeordnet sind, wobei beide Spulen (1, 2) bei Gebrauch ein wechselndes elektromagnetisches Feld erzeugen, wobei das wechselnde elektromagnetische Feld der ersten (1) und der zweiten Spule (2) gegeneinander wirken, wobei die Spulen (1, 2) zusammen drehbar und/oder verlagerbar sind, um die Mittellinie (5) der Spulen (1, 2) zu ändern, und wobei ein Schlauch aus nichtleitendem Material innerhalb der Spulen (1, 2) angeordnet ist, so dass sich der Schlauch bei Gebrauch zwischen den Spulen (1, 2) und dem leitenden Material (3) befindet, und wobei die erste (1) und die zweite (2) Spule so positioniert sind, dass das leitende Material (3), das frei schwebend zwischen der ersten Spule (1) und der zweiten Spule (2) gehalten wird, verdampft, und das verdampfte Material entlang der Richtung der Mittellinie (5) der Spulen (1, 2) innerhalb des Schlauchs aus nichtleitendem Material zu dem zu beschichtenden Substrat fließt.

2. Vorrichtung nach Anspruch 1, wobei die Spulen (1, 2) Wicklungen (1a, 1 b, 1 c; 2a, 2b, 2c) aufweisen, die alle im Wesentlichen geschlossene Regelkreise sind.

3. Vorrichtung nach einem der Ansprüche 1 bis 2, wobei die Spulen (1, 2) jeweils eine separate Stromversorgung bzw. -zuführung haben.

4. Vorrichtung nach einem der Ansprüche 1 bis 2, wobei die Spulen (1, 2) verbunden sind und dieselbe Stromversorgung haben.

5. Vorrichtung nach Anspruch 4, wobei die Spulen (1, 2) in entgegengesetzte Richtungen gewickelt sind.

6. Vorrichtung nach einem der vorhergehenden Ansprüche, wobei sich die erste Spule (1) im Wesentlichen oberhalb der zweiten Spule (2) befindet.

7. Vorrichtung nach Anspruch 6, wobei die erste Spule (1) dieselbe Anzahl an Wicklungen oder weniger Wicklungen als die zweite Spule (2) hat.

8. Vorrichtung nach einem der vorhergehenden Ansprüche, wobei die erste (1) und die zweite (2) Spule spiegelsymmetrisch sind.

9. Verfahren zur Erzeugung einer Menge an frei schwebendem leitenden Material (3), das eine Vorrichtung gemäß einem der vorhergehenden Ansprüche verwendet, **dadurch gekennzeichnet, dass** das leitende Material (3) zwischen den durch die beiden Spulen (1, 2) erzeugten elektromagnetischen Feldern eingeschlossen ist, um aufgrund der Erwärmung durch den Strom und die Frequenz in den Spulen zu verdampfen, wobei das verdampfte leitende Material im Wesentlichen entlang der Richtung der Mittellinie (5) der Spulen (1, 2) zur Beschichtung eines Substrats geleitet bzw. gelenkt wird.

10. Verfahren nach Anspruch 9, wobei die Spulen (1, 2) zusammen manipuliert werden, um das verdampfte leitende Material mit einem oder mehreren Freiheitsgraden zu lenken.

11. Verfahren nach Anspruch 10, wobei die Spulen (1, 2) mit sechs Freiheitsgraden manipuliert werden.

12. Verfahren nach einem der Ansprüche 9 bis 11, wobei die Stärke des elektromagnetischen Felds in den zwei Spulen (1, 2) dergestalt ist, dass das leitende Material (3), das zwischen den elektromagnetischen Feldern eingeschlossen ist, in Richtung auf die Mittellinie (5) der Spulen (1, 2) gezwungen wird.

## Revendications

1. Appareil pour la lévitation d'une quantité de matériau conducteur (3), comprenant une bobine pour maintenir le matériau en lévitation en utilisant un courant électrique variable dans la bobine, l'appareil comprenant deux bobines (1, 2), une première bobine (1) et une deuxième bobine (2), **caractérisé en ce que** les deux bobines (1, 2) ont été placées dans une chambre à vide pour un vide d'au moins 10⁻³ mbar en utilisation, les deux bobines (1, 2) générant un champ électromagnétique alterné en utilisation, le champ électromagnétique alterné de la première (1) et de la deuxième (2) bobine se neutralisant mutuellement, dans lequel les bobines (1, 2) peuvent être mises en rotation et/ou déplacées ensemble afin de modifier l'axe (5) des bobines (1, 2), et dans lequel un tube de matériau non conducteur est placé à l'intérieur des bobines (1, 2) de telle manière que le tube est présent entre les bobines (1, 2) et le matériau conducteur (3) en utilisation, et dans lequel les première (1) et deuxième (2) bobines sont positionnées de telle manière que le matériau conducteur (3) qui est maintenu en lévitation entre la première bobine (1) et la deuxième bobine (2) est évaporé et le matériau évaporé s'écoule suivant la direction de l'axe (5) des bobines (1, 2)à l'intérieur du tube de matériau non conducteur, jusqu'au substrat à enduire.

2. Appareil selon la revendication 1, dans lequel les bobines (1, 2) ont des enroulements (1a, 1b, 1c ; 2a, 2b, 2c) qui forment tous des boucles substantiellement fermées.

3. Appareil selon la revendication 1 ou 2, dans lequel les bobines (1, 2) ont chacune une alimentation électrique séparée.

4. Appareil selon la revendication 1 ou 2, dans lequel les bobines (1, 2) sont reliées et ont la même alimentation électrique.

5. Appareil selon la revendication 4, dans lequel les bobines (1, 2) sont enroulées dans des sens opposés.

6. Appareil selon l'une quelconque des revendications précédentes, dans lequel la première bobine (1) est située sensiblement au-dessus de la deuxième bobine (2).

7. Appareil selon la revendication 6, dans lequel la première bobine (1) a le même nombre d'enroulements ou moins d'enroulements que la deuxième bobine (2).

8. Appareil selon l'une quelconque des revendications précédentes, dans lequel les première (1) et deuxième (2) bobines présentent une symétrie en miroir.

9. Procédé pour générer une quantité de matériau conducteur en lévitation (3) en utilisant un appareil selon l'une quelconque des revendications précédentes, **caractérisé en ce que** le matériau conducteur (3) est emprisonné entre les champs électromagnétiques générés par les deux bobines (1, 2) afin de s'évaporer en raison du chauffage créé par le courant et la fréquence présents dans les bobines, dans lequel le matériau conducteur évaporé est dirigé essentiellement suivant la direction de l'axe (5) des bobines (1, 2) dans le but d'enduire un substrat.

10. Procédé selon la revendication 9, dans lequel les bobines (1, 2) sont manipulées ensemble afin de diriger le matériau conducteur évaporé avec un ou plusieurs degrés de liberté.

11. Procédé selon la revendication 10, dans lequel les bobines (1, 2) sont manipulées avec six degrés de liberté.

12. Procédé selon l'une quelconque des revendications 9 à 11, dans lequel la puissance du champ électromagnétique dans les deux bobines (1, 2) est propre à forcer le matériau conducteur (3) piégé entre les champs électromagnétiques à se diriger vers l'axe (5) des bobines (1, 2).
